Europäisches Patentamt

European Patent Office

Office européen des brevets

(11) Publication number: **0 488 554 A2**

# EUROPEAN PATENT APPLICATION

(21) Application number: **91310540.9**

(22) Date of filing: **14.11.91**

(51) Int. Cl.⁵: **H01L 21/60, H01L 23/498**

(30) Priority: **28.11.90 JP 323424/90**

(43) Date of publication of application:
**03.06.92 Bulletin 92/23**

(84) Designated Contracting States:
**DE FR GB**

(71) Applicant: **International Business Machines Corporation**
**Old Orchard Road**
**Armonk, N.Y. 10504(US)**

(72) Inventor: **Yonehara, Katsuyuki, Lions-mansion 105, 134-1**
**Tanaka-cho,**
**Nishinotouindouri-marutamachi-sagaru**
**Nakagyou-ku, Kyoto-shi, Kyoto-fu(JP)**

(74) Representative: **Mitchell, Allan Edmund et al**
**IBM United Kingdom Limited Intellectual**
**Property Department Hursley Park**
**Winchester Hampshire SO21 2JN(GB)**

(54) **Tab tape, tab tape package and method of bonding same.**

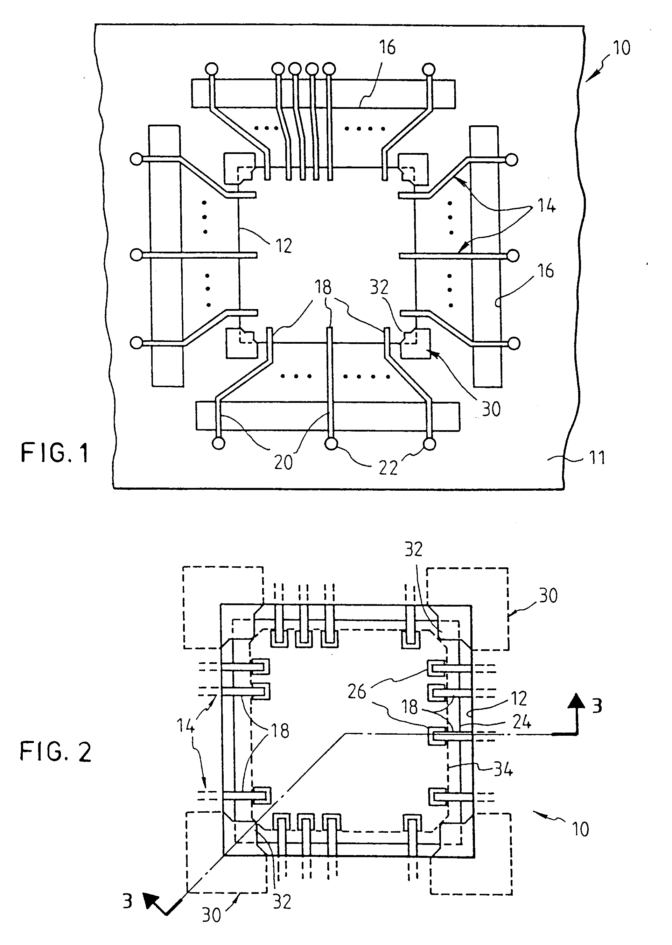

(57) A TAB tape 10 comprises an insulating tape having a multiplicity of openings 12 (Figure 2), each surrounded by metallic leads 14 having inner lead portions 18 projecting into the opening 12. In the corners of the opening 12 on the tape are formed metallic chip pressure members 30 having tips 32 projecting into the opening 12 between groups of inner lead portions 18. A chip 24 is positioned in each opening 12 in turn with chip pads 26 aligned with the inner lead portions 18. A bonding tool 34 is moved downwardly into engagement with the inner lead portions 18 to force them into contact with the chip pads 26 and to thermocompressively attach them thereto. The corners of the tool 34 engage and bend the tips 32 into engagement with the surface of the chip 24, so that when the tool is lifted tie chip is prevented from following due to adhesion of the tool and leads.

FIG. 2

EP 0 488 554 A2

This invention relates to TAB (Tape Automated Bonding) tape techniques, and more specifically to TAB tapes, TAB tape packages and methods of bonding the same.

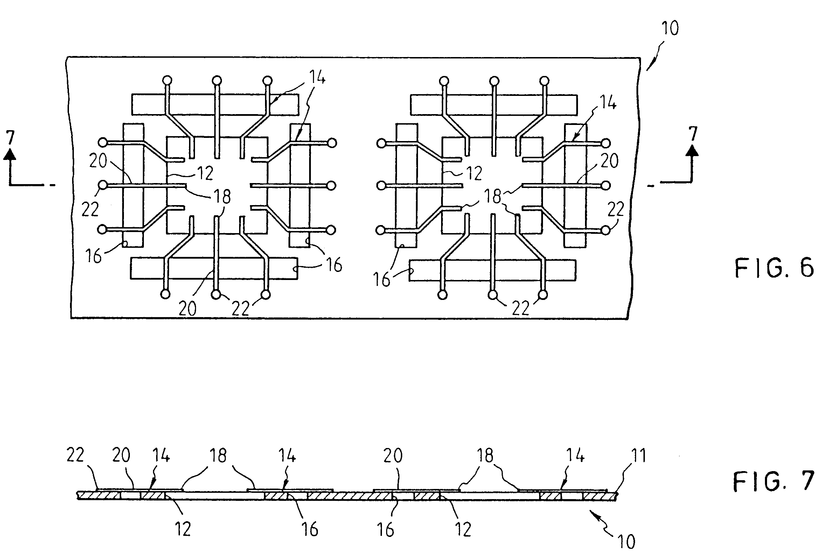

TAB tape is widely used in manufacturing semiconductor integrated circuit packages. A conventional TAB tape 10, Figures 6 and 7 comprises an insulating tape 11 of a material such as polyimide, through which tape there is a multiplicity of openings 12, each shaped to receive a semiconductor chip 24. The insulating tape 11 has an opening 12 at each chip attaching position and leads 14 are formed on the tape 11 around each opening 12. Four elongated slots 16 are formed on the tape 11 around each opening 12. Each lead 14 has an inner lead portion 18 projecting into opening 12 and an outer lead portion 20 extending across slot 16. The outer lead portions 20 terminate in test pads 22 which are used for circuitry testing.

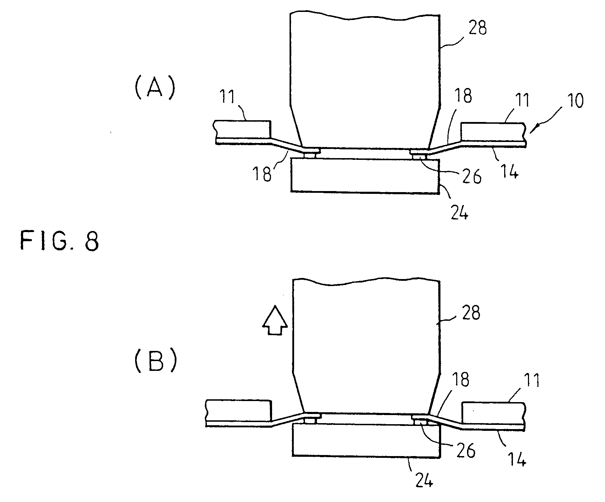

When a chip is to be attached to a TAB tape, a semiconductor chip is positioned in opening 12, and inner lead portions 18 are connected to the pads of the chip by the use of a bonding tool 28 (Figure 8) called Thermode. The tape 10 is placed so that leads 14 face downward (Figure 8 (A)), and tape 11 and chip 24 are so positioned that inner lead portions 18 and electrode pads 26 of the chip 24 are aligned with each other. All the inner lead portions 18 are thermocompressively bonded simultaneously to chip pads 26 by means of the bonding tool 28.

The top end of the bonding tool 28 is formed of a hard material such as a sintered diamond, and the leads 14, are usually formed of copper, plated with tin. This bonding method is satisfactory when the number of leads is small, but a problem of lift-up of chips occurs as the number of leads is increased. When the number of leads increases, the contact area between the bonding tool and leads increases and the adhesive force between the bonding tool and leads increases. For this reason, when the bonding tool is raised after the bonding, it may happen that chip 24 (Figure 8 (B)) is lifted up at the same time, making the leads deform, whereby the inner lead portions 18 are brought in contact with the edge of chip 24.

Although the surface of a chip is usually covered with a surface protecting layer such as polyimide, it is not always completely covered to its edge portion. In addition, there are chips of the type in which an exposed wiring pattern for evaluating the chip characteristics is provided in the edge portion. Accordingly, it is not desirable for the leads to touch the chip.

The above problem can be solved by adding a work step to restore the deformed leads, but such work is inefficient and also may damage the leads or chip. Another method can be imagined, in which a chip is sucked by vacuum and fixed that way at the time of bonding. However, this method would be complex and expensive because it requires a vacuum control mechanism, and it also requires extra control time. Although forming the bonding tool and leads with materials which do not adhere to each other can be considered as a further method, no practical technique for this has been proposed.

It is preferable to ensure the prevention of contact between the leads and the chip even after the bonding. This is not ensured by the above-mentioned vacuum suction method.

Accordingly, this invention seeks to provide a TAB tape, package and bonding method for preventing a chip from being lifted up by adhesion of the bonding tool with the leads in the bonding of the TAB leads.

This invention also seeks to provide a TAB package which can prevent contact between the leads and the chip.

From one aspect, the invention provides a TAB tape which includes insulating tape having openings at respective chip attaching positions, and leads formed on the insulating tape and extending into respective openings to be connected to pads of the respective chips when the chips are attached, characterised by chip pressure means on the insulating tape extending into each opening to prevent passage of a chip therethrough.

Preferably, the attachment of the chips is by a bonding tool pressing the lead extensions against the chip pads, and the chip pressure means extends into each opening to prevent a chip from being lifted up by adhesion between the bonding tool and the leads when the chip is attached.

The invention extends to a TAB tape package comprising such a TAB tape, in which the leads have inner lead portions extending into the opening and outer lead portions extending from the insulating tape, a chip is disposed in the opening and has pads connected to the inner lead portions, and the chip pressure means extends into the opening to prevent contact between the inner lead portion and the chip by engagement with the surface of the chip at the side of the pad.

The invention includes a method of bonding a TAB tape, comprising preparing such a tape, aligning the tape with respect to a chip so that the lead portions in a selected opening are positioned on the pads of the chip to be attached and projecting portions of the chip pressure means in the opening are positioned on the surface at the side of the pads, moving a bonding tool downwardly to the selected opening, the bonding tool having a bottom surface for thermocompressively bonding the lead portions to the pads and inclined surfaces for engaging the projecting portions and bending the projecting portions towards the surface at the side of the pads by engagement of the inclined surfaces with the projecting portions during the downward movement of said bonding tool.

In an embodiment of TAB tape, to solve the problems the TAB tape is so formed as to have chip pressure means extending into the openings in which chips are to be attached. The chip pressure means are preferably formed of the same material as the leads and provided at the same side as the leads and in the four corners of the openings in which the chips are to be attached. The chip pressure means act to engage with the surface of a chip at the side of the pads thereby preventing the chip from lifting or moving to the leads.

How the invention can be carried into effect is hereinafter particularly described with reference to the accompanying drawings, in which:

Figure 1 is a schematic representation of part of a TAB tape according to this invention;

Figure 2 is a schematic representation of part of the tape of Figure 1 with a chip placed in an opening of the tape;

Figure 3 is a schematic sectional representation illustrating the bonding operation on the lines 3-3 of Figure 2;

Figure 4 is a representation showing other examples of chip pressure member;

Figure 5 is a schematic perspective representation of a TAB tape package according to this invention;

Figure 6 is a schematic representation showing a conventional TAB tape;

Figure 7 is a sectional view on line 7-7 of Figure 6; and Figure 8 is a representation showing conventional bonding operation.

Corresponding elements in Figures 1 to 5 carry the same reference numerals as in Figures 6 to 8.

In an exemplary embodiment of the invention, a TAB tape 10 (Figure 1) includes a length of insulating tape 11 of polyimide, which is 125 microns thick. A multiplicity of openings 12 are formed through the tape 11 in the positions in which chips are to be attached. A total of two hundred and sixty-eight leads 14 is provided for each opening 12 and these are formed on the tape 11 of 35 micron-thick copper having a tin surface coating. Detailed structures such as sprocket holes are omitted in the figure.

In each of the four corners of each opening 12 (Figure 1), a chip pressure member 30 is provided. A portion 32 of each chip pressure member 30 extends into opening 12. Leads 14 are usually formed by patterning a copper layer bonded to the polyimide tape. The chip pressure members 30 are preferably formed on the same side of the tape 11 and of the same material as leads 14, conveniently by patterning the copper layer so as simultaneously to form leads 14 and chip pressure members 30.

The tape 10 (Figure 2) and chip 24 are aligned so that inner lead portions 18 and electrode pads 26 of semiconductor chip 24 align with each other at the time of bonding. In this example, the tape is placed so that the leads face downward. Projecting portions 32 of chip pressure members 30 overhang the four corners of chip 24 so as to be capable of engaging with the surface of chip 24 at the side of pads 26.

The chip pressure member portions 32 extend to such an extent as to overlap slightly the bottom of the bonding tool 28, whose shape is represented by the broken line 34.

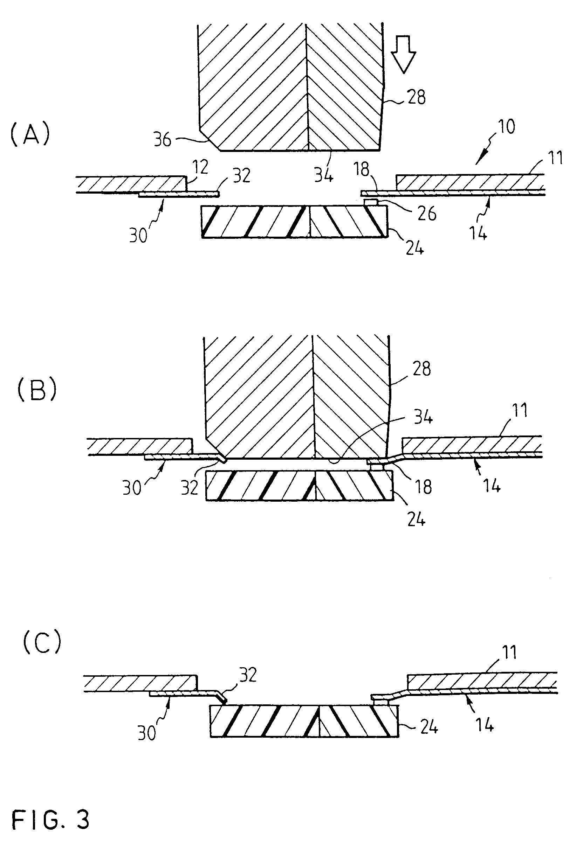

The shape 34 of the bottom of the tool 28 is such that, during bonding (Figure 3) the bottom contacts with all the inner lead portions 18. The corners of the bottom are cut away to form inclined surfaces 36 so as not to engage the main part of the projecting portions 32 of chip pressure members 30, but only the extremities. The inclined surfaces 36 are provided in the corners of the bottom surface 34 of the bonding tool 28 corresponding to the chip pressure members 30.

When the bonding tool 28 (Figure 3(A)) is lowered, the four inclined surfaces 36 of the bonding tool are aligned with the projecting portions 32 of chip pressure members 30. As the bonding tool moves further downwardly (Figure 3(B)), the inner lead portions 18 are engaged and depressed to thermocompressively bond them to pads 26. At the same time the inclined surfaces 36 engage the extremities or tips of the projecting portions 32 of the chip pressure members 30 and bend them down. When the bonding tool 28 rises after the bonding, the lead portions 18 may adhere to the bottom surface. If so and the chip lifts, the projecting portions 32 of the chip pressure members 30 engage with the upper surface of the chip at the side of the pads to block further movement, and thus lifting-up of the chip and hence the deformation of the leads can be prevented. The projecting portions 32 which were bent act as spacers to maintain the spacing between the chip surface and the lead portions 18. In order to bend the projecting portions 32 simultaneously with the bonding of the leads, a difference needs to occur between the height of the chip pressure members 30 and that of the bottom surface of the tool in its lowest position. If gold is used as the material for chip pads 26, the thickness of the gold pads is ordinarily reduced by a factor of several numbers. Thus, the design needs to be made such that the necessary difference in height is obtained, considering the thickness change. Even if the tip of the projecting portions 32 touches the chip surface, no problem occurs because the chip surface except for the pads is covered with a surface protecting insulating layer, a polyimide layer in this example, and the tip of the projecting portions 32 merely touch the polyimide layer.

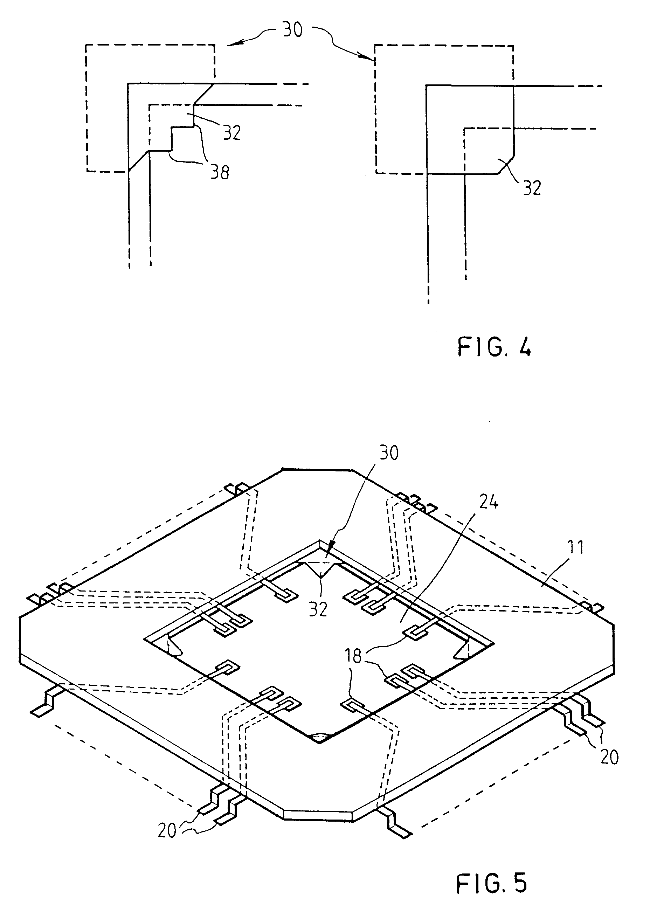

Two alternative forms of chip pressure member 30 are shown in Figure 4. In one, the projecting portion has two protrusions 38. In the other, the projecting portion 32 is substantially rectangular. It will be apparent that the shape of the chip pressure members 30 is not limited to these forms, but they can be formed to any suitable shape.

After bonding, the chip is tested using test pads 22 (Figure 1). By resin-sealing the surface of the chip at the side of the pads and then cutting along the outer edge of slots 16 as needed, a single chip assembly is separated from the tape (Figure 5). Outer lead portions 20 are moulded into a shape suitable for being attached to a circuit board (not shown), whereby a TAB package is formed.

In addition to the above embodiments, various modifications are possible. For example, the chip pressure members may be formed on the surface of the insulating tape which is opposite to that on which the leads are formed. In this case, the chip pressure members in the four corners need not always be separated. Furthermore, the chip pressure members need not always be provided in the four corners of a chip if the lead density is relatively small and if space for engagement of the chip pressure members can be secured in positions other than the four corners. Moreover, if the spacing between the chip surface and the leads can be maintained after bonding, the chip pressure members need not be of the same material as the leads. In addition, although the TAB tape was bonded with the leads facing downward, it may be bonded with the leads facing upward.

From the described embodiments of this invention, it will be appreciated that a chip can easily and securely be prevented from being lifted up by the adhesion between the bonding tool and the leads at the time of bonding. In addition, a TAB package structure can be obtained wherein the spacing between the leads and the chip surface can be maintained and thus the contact of the leads with the chip can be prevented even after the bonding.

It will be appreciated that the chip pressure members are so called because, if the chip starts to lift lip by reason of adhesion between the bonding tool and the leads thermocompressively bonded to the chip pads, the chip pressure members engage the chip and prevent such lift-up, pressing against the chip as the bonding tool rises. For the preferred result, the tips of the chip pressure members should be engaged by the inclined surfaces of the corners of the bottom of the tool and bent into contact with the surface of the chip, but no further. Such an arrangement ensures that the leads are not damaged by lift-up of the chip. However, it will be appreciated that even if the chip pressure members are not contacted by the bottom of the tool, or are not bent into contact, the chip will engage the chip pressure members and be stopped if any lift-up occurs. This reduces the danger of damage to the leads.

It will also be appreciated that the chip pressure members may be formed simultaneously with the leads on the insulating tape by appropriate etching of a metallisation layer on the tape.

## Claims

1. A TAB tape which includes insulating tape (11) having openings (12) at respective chip attaching positions, and leads (14) formed on the insulating tape (11) and extending (18) into respective openings (12) to be connected to pads (26) of the respective chips (24) when the chips are attached, characterised by chip pressure means (30) on the insulating tape (11) extending (32) into each opening (12) to prevent passage of a chip therethrough.

2. A TAB tape according to claim 1, in which the attachment of the chips is by a bonding tool (28) pressing the lead extensions (18) against the chip pads (26), and the chip pressure means (30) extends (32) into each opening (12) to prevent a chip (24) from being lifted up by adhesion between the bonding tool (28) and the leads when the chip is attached.

3. A TAB tape according to claim 1 or claim 2 wherein the chip pressure means (30) comprises metallic members formed on the insulating tape (11).

4. A TAB tape according to claim 3, wherein the metallic members (30) are formed on the insulating tape (11) on the same side as the leads (14).

5. A TAB tape according to claims 3 or 4, wherein the metallic members (30) are formed of the same material as the leads (14).

6. A TAB tape according to any preceding claim, wherein the chip pressure means (30) extend into each opening (12) at the four corners thereof.

7. A TAB tape according to any preceding claim, wherein the chip presure means (30) and the bonding tool (28) interengage during chip attachment so that the chip pressure means engages the surface of the chip to be attached away from the pads.

8. A TAB tape package comprising a TAB tape according to any preceding claim, in which the leads (14) have inner lead portions (18) extending into the opening (12) and outer lead portions (20) extending from the insulating tape (11), a chip (24) is disposed in the opening and has pads (26) connected to the inner lead portions (18), and the chip pressure means (30) extends into the opening to prevent contact between the inner lead portion (18) and the chip (24) by engagement with the surface of the chip at the side of the pads (Figure 5).

9. A TAB tape package according to claim 8, wherein the chip pressure means (30) has a projecting portion (32;38) bent towards the surface of the chip (24).

10. A method of bonding a TAB tape, comprising preparing a TAB Tape according to any of claims 1 to 7, aligning the TAB tape with respect to a chip (24) so that the lead portions in a selected opening (12) are positioned on the pads (26) of the chip (24) to be attached and projecting portions (32) of the chip pressure means in the opening are positioned on the surface at the side of the pads, moving a bonding tool downwardly (28) to the selected opening, the bonding tool (28) having a bottom surface for thermocompressively bonding the lead portions (18) to the pads (26) and inclined surfaces (36) for engaging the projecting portions (32) and bending the projecting portions towards the surface at the side of the pads by engagement of the inclined surfaces with the projecting portions during the downward movement of said bonding tool.

FIG. 1

FIG. 2

(A)

(B)

(C)

FIG. 3

FIG. 4

FIG. 5

FIG. 6

FIG. 7

(A)

28

11    18    11    10

18    26    14

24

FIG. 8

(B)

28

11

18    11

26    14

24